# EUROPÄISCHE PATENTSCHRIFT

(11) **EP 0 326 828 B1**
(45) Veröffentlichungstag und Bekanntmachung des Hinweises auf die Patenterteilung: **04.09.1996**
(21) Anmeldenummer: 89100574.6
(22) Anmeldetag: 13.01.1989
(51) Int. Cl.: H01L 29/732, H01L 23/52, H01L 27/06

(54) **Leistungstransistor**
Power transistor
Transistor de puissance

(30) Priorität: 30.01.1988 DE 3802821
(43) Veröffentlichungstag der Anmeldung: 09.08.1989
(73) Patentinhaber: ROBERT BOSCH GMBH, 70442 Stuttgart (DE)
(72) Erfinder: Conzelmann, Gerhard, Dipl.-Phys., D-7022 Leinfelden-Oberaich (DE); Fiedler, Gerhard, Dipl.-Ing. (FH), D-7441 Neckartailfingen (DE); Olbrich, Ludger, Dipl.-Phys., D-7410 Reutlingen (DE)

(56) Entgegenhaltungen:
- EP-A- 0 181 975
- FR-A- 2 392 500
- FR-A- 2 503 933
- GB-A- 2 135 824
- US-A- 3 670 219
- US-A- 3 704 398
- US-A- 4 656 496

## Beschreibung

### Stand der Technik

Die Erfindung betrifft einen monolithisch integrierten Leistungstransistor nach der Gattung des Hauptanspruchs.

Es sind bereits monolithisch integrierte Leistungstransistoren dieser Art bekannt, bei denen die Zellen, aus denen der Leistungstransistor besteht, gleich oder mindestens einander ähnlich ausgebildet sind, wobei die Zellen, insbesondere ihre Emitter, sehr viel länger als breit sind. Wegen der Spannungsabfälle auf der Emitter- und Kollektorleitung einer Zelle ist ihre Länge jedoch begrenzt. Um diese Spannungsabfälle in nullter Näherung zu kompensieren, ist es des weiteren bekannt, den Anschluß für den Emitter am einen Ende der Zelle, den Anschluß für den Kollektor am anderen Ende der Zelle anzuordnen.

### Vorteile der Erfindung

Der erfindungsgemäße monolithisch integrierte Leistungstransistor mit den kennzeichnenden Merkmalen des Hauptanspruchs hat demgegenüber den Vorteil, daß der Emitter und der Kollektor des monolithisch integrierten Leistungstransistors mit Hilfe einer einlagigen Anschlußmetallisierung angeschlossen werden können. Ein weiterer Vorteil besteht darin, daß das Verhältnis Länge zu Breite der einzelnen Zellen des Leistungstransistors im Vergleich zu den bekannten Leistungstransistoren reduziert werden kann und durch eine zweizeilige Anordnung in etwa quadratische Chipabmessungen für den gesamten Leistungstransistor erreicht werden, was insbesondere für lineare Leistungstransistoren, die für große Ströme und Verlustleistungen, beispielsweise für 30 A bzw. 100 bis 200 W, ausgelegt sind, von Vorteil ist. Weitere Vorteile ergeben sich aus den Unteransprüchen 2 bis 20 und aus der Beschreibung.

### Zeichnung

Anhand der Zeichnung wird die Erfindung näher erläutert.

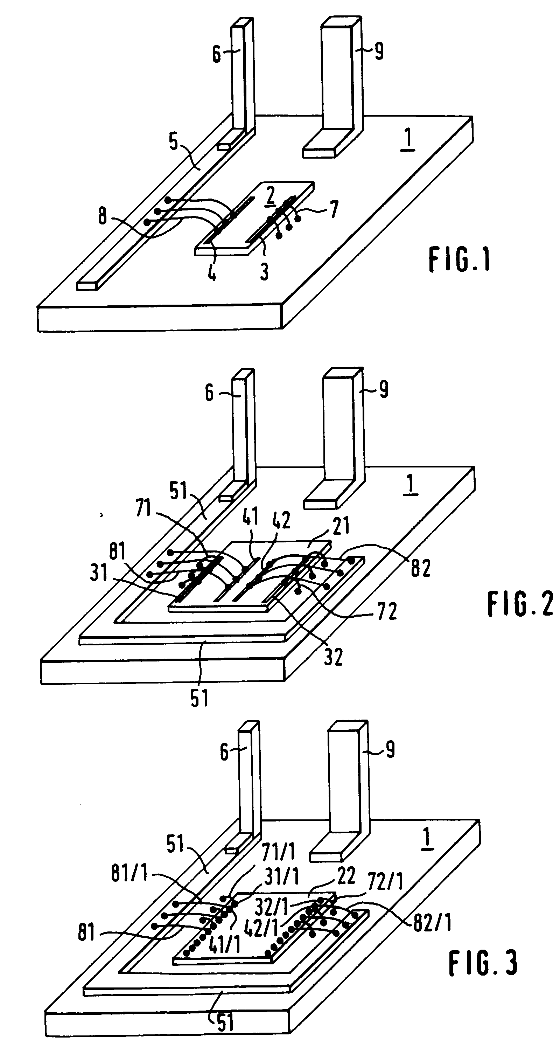

Als bekannte Anordnung zeigt Figur 1 den montierten Chip eines Leistungstransistors mit nur einer Zeile von Zellen.

Figur 2 zeigt dasselbe mit einem Chip, der durch einfaches Spiegeln des Chips von Figur 1 an der kollektorseitigen Kante entstanden ist.
In Figur 3 ist ein montierter Chip gemäß der Erfindung dargestellt,
in Figur 4 das Plot des Layouts einer Zelle mit den Anschlußflecken für Emitter und Kollektor,
in Figur 5 die dazugehörende Struktur für einen möglichen Prozeß zur Darstellung des Leistungs-IC,
in Figur 6 der Ausschnitt einer Zelle des Leistungstransistors mit einem variablen Pinchwiderstand zwischen Basiskontakt und Emitterdiffusionszone und
in Figur 7 der Ausschnitt eines Schaltbilds mit sich im Fehlerfall selbstabtrennenden Zellen und
in Figur 8 das Plot eines Ausschnitts vom gesamten Layout eines zweizeiligen Leistungstransistors.

### Beschreibung der Erfindung

Mit modernen Bondautomaten lassen sich in der Montage auch Halbleiterbauelemente mit einer Vielzahl von Anschlüssen wirtschaftlich herstellen. Die verarbeitbaren Drahtstärken liegen beispielsweise bei Durchmessern von 50 bis 75 µm (2 bis 3 mil). Da sich mit einem Bonddraht von 50 µm Ströme von mehr als 1 A übertragen lassen, wird vorgeschlagen, bei hinreichend langen Zellen Emitter- und Kollektoranschluß nebeneinander an der Außenkante des Chips anzuordnen und eine zweite Zeile durch Spiegeln der ersten Zeile an der den Anschlüssen abgewandten Seite darzustellen. Es ist vorteilhaft, beide Zeilen thermisch zu entkoppeln durch einen zwischen ihnen liegenden Abstand mit einer Breite, die mindestens gleich der Chipdicke ist. Dieser Bereich läßt sich vorteilhaft für Versorgungsleitungen und Schaltungskomponenten verwenden.

Die vorgeschlagene Lösung erlaubt Zellen mit einem Dauerstrom von 1 A und darüber bei einer Zellbreite von 300 bis 400 µm; sie stellt einen tragbaren Kompromiß für die Querschnitte der Leiterbahnen und die abzuführende Verlustleistung dar. Wird der Leistungstransistor in linearen Schaltungen eingesetzt, so sind Maßnahmen zur Verhinderung des "second breakdown" erforderlich, die, sollen sie effektiv sein, eine relativ hohe Sättigungsspannung bedingen. Es ist deshalb vorgesehen, mit einem parallelgeschalteten Schalttransistor eine niedrige Sättigungsspannung zu errreichen. Außerdem sind Mittel zum selbsttätigen Abtrennen defekt werdender Zellen vorgesehen (''Selbstheileffekt").

In Figur 1 ist 1 eine aus gut wärmeleitendem Material, wie z.B. Kupfer, bestehende Grundplatte, 2 der Chip eines Leistungs-IC mit einem nur eine Zeile aufweisenden Leistungstransistor, 3 die Anschlußmetallisierung auf dem Chip für den negativen mit der Grundplatte verbundenen Pol, 4 die entsprechende Anschlußmetallisierung für den Kollektor, 5 eine metallisierte, beispielsweise kupferplattierte und vernickelte Keramikleiste zum Anschluß des Kollektors, der über den Anschlußstift 6 nach außen geführt ist, ferner sind 7 die Bonddrähte zum Verbinden der Anschlußmetallisierung 3 für den negativen Pol mit der Grundplatte und 8 die zum Verbinden der Anschlußmetallisierung 4 des Kollektors mit dem Kollektoranschluß 5; 9 ist der Anschluß für die Grundplatte. Von den vielen Bonddrähten 7, 8 sind stellvertretend nur jeweils drei eingezeichnet. Auf die Darstellung der übrigen Anschlüsse der integrierten Schaltung wurde verzichtet, da sie nicht Gegenstand der Erfindung sind.

In Figur 2 sind gleiche Teile auch wieder gleich bezeichnet. Der zweizeilige Chip 21 ist durch Spiegeln aus dem Chip 2 entstanden, entsprechend sind jetzt jeweils zwei Anschlußmetallisierungen für den negativen Pol 31, 32 und den Kollektor 41, 42 sowie die Bonddrähte 71, 72 bzw. 81, 82 vorhanden; die metallisierte Keramikleiste 51 ist u-förmig um den Chip gelegt. Es ist ersichtlich, daß die Bonddrähte für den Kollektoranschluß besonders lang werden und den Bonds auf 41, 42 beidseitig Schaltungsteile benachbart sind. Ein zweizeiliger Chip ist zum Beispiel aus der Patentanmeldung FR-A-2 503 933 bekannt.

In der erfindungsgemäßen Anordnung von Figur 3 mit einem zweizeilig ausgeführten Leistungstransistor 22 sind die Anschlüsse von Emitter 31/1, 31/2, ..., 31/n bzw. 32/1, 32/2, ..., 32/n und Kollektor 41/1, 41/2, ..., 41/n bzw. 42/1, 42/2, ..., 42/n nach außen gezogen und abwechselnd für jede Zelle ausgeführt. In Figur 3 sind der Übersichtlichkeit halber nur die ersten Anschlußflecken und ebenso nur die ersten Bonddrähte 71/1, 72/1 bzw. 81/1, 82/1 bezeichnet; die weiteren Teile sind bereits bekannt.

In den Figuren ist beispielhaft ein möglicher Prozeß zur Darstellung des Gegenstands der Erfindung, in den Strukturen stilisiert ohne den Versatz durch Unterätzung und Unterdiffusion etc., wiedergegeben.

Es bedeuten:

| | |
|---|---|
| 000 | Substrat (p⁻) |
| 001 | Vergrabene Schicht ("buried layer") (n⁺) |
| 021 | Untere Isolierungsdiffusion (p⁺) |
| 100 | Epitaxie (n⁻) |
| 031 | Obere Isolierungsdiffusion (p⁺) |
| 041 | Kollektoranschlußdiffusion (n⁺) |
| 051 | Basisdiffusion (p) |
| 061 | Emitterdiffusion (n⁺) |
| 007 | Deckoxid |
| 008 | Metallisierung |
| 009 | Schutzschicht |

Die beiden Isolierungsdiffusionen 021, 031 sind weit, die Kollektoranschlußdiffusion 041 eng von links unten nach rechts oben, das strukturierte Metall 008 dagegen von links oben nach rechts unten schraffiert wiedergegeben. Die Schutzschicht 009 kann aus einem Silan oder Plasma-Oxid oder aus einem Plasma-Nitrid bestehen.

Die Breite einer Zelle bei linearen Leistungstransistoren ist einerseits gegeben durch die abzuführende Verlustleistung, andererseits aber bestimmt durch die nebeneinanderliegenden Anschlußflecken für Emitter und Kollektor. Damit ist genügend Platz vorhanden, um weitere Komponenten unterzubringen, wie etwa einen zusätzlichen Schalttransistor, mit dem sich eine niedrige Sättigungsspannung erreichen läßt und etwa eine Zenerdiode, die durch die Parallelschaltung der Zenerdioden aller Zellen eine Leistungszenerdiode zum Schutz des Leistungstransistors ergibt.

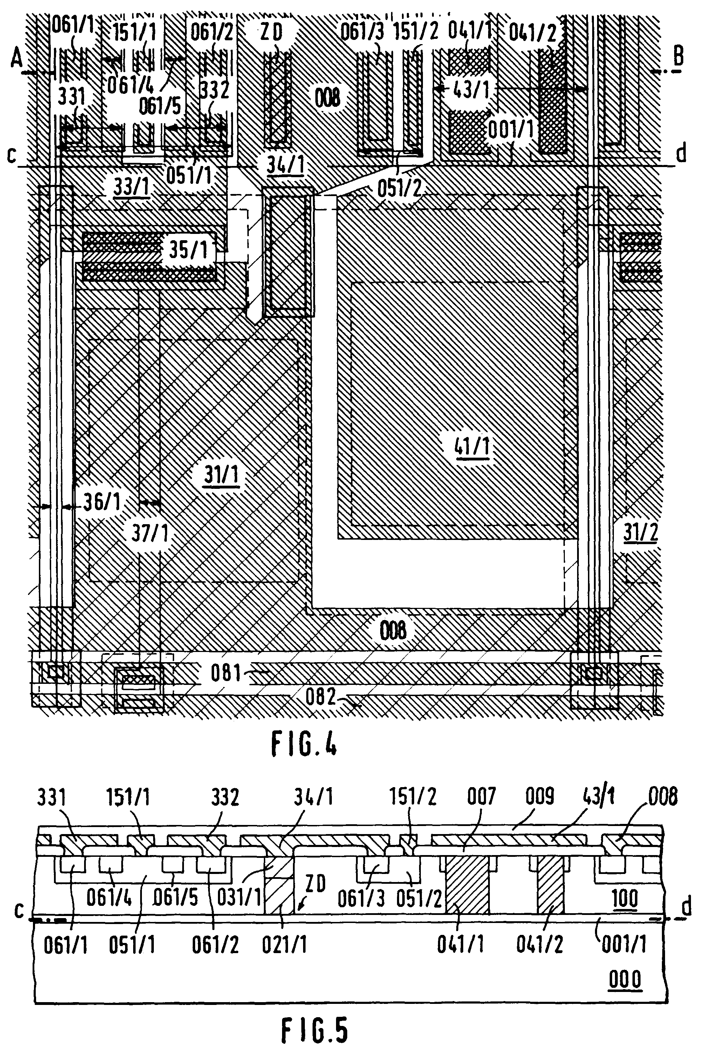

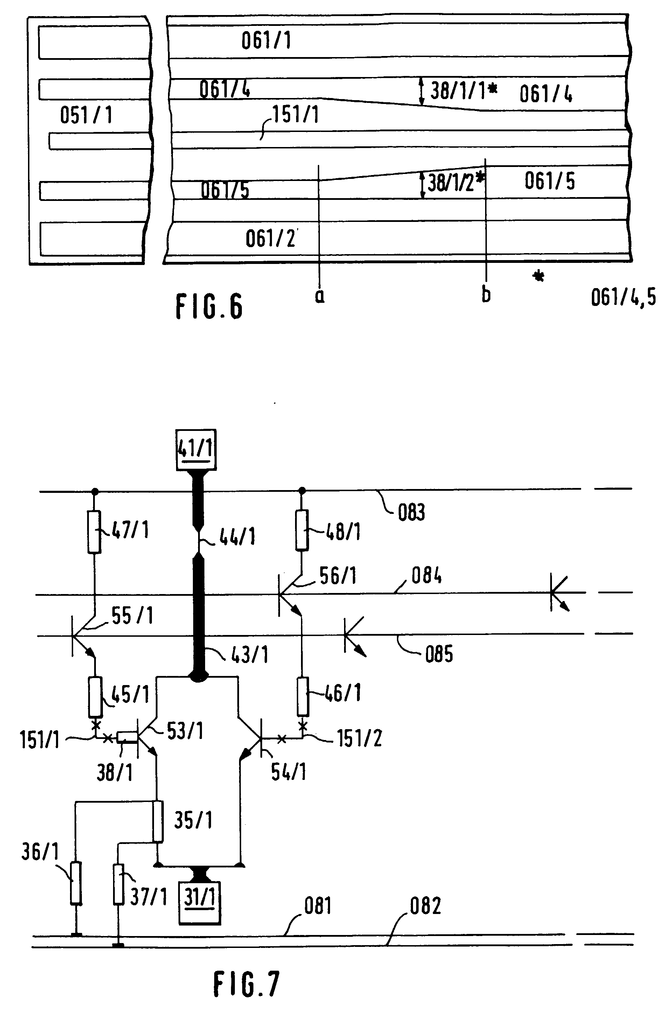

In den Figuren 4 und 5 sind 31/1, 41/1 die Anschlußflecken für Emitter und Kollektor der ersten Zeile und ersten Zelle des Leistungstransistors; der Emitter des linear arbeitenden Teiltransistors 53/1 gemäß Figur 7 besteht aus den beiden Emitterdiffusionsstreifen 061/1, 061/2, die über die Metallisierungen 331 und 332 - zusammengefaßt mit 33/1 - und über den Strommeßwiderstand 35/1 mit dem Anschlußfleck 31/1 verbunden sind. Die genannten Emitterstreifen 061/1, 2 liegen in der Basisdiffusionszone 051/1, die über das Kontaktfenster und die Metallisierung 151/1 an die nicht dargestellte Steuerschaltung angeschlossen ist; zwischen 151/1 und den beiden Emitterdiffusionsstreifen 061/1, 2 sind die Emitterdiffusionen 061/4 und 061/5 angeordnet; sie bilden den unmittelbar unter ihnen liegenden Pinchwiderstand 38/1 zur Stabilisierung der Stromverteilung des Teiltransistors und der Parallelschaltung aller Zellen zum Leistungstransistor. Mittels unterer Isolierungsdiffusion 021/1, die auf dem buried-layer 001/1 aufsitzt, ist die Zenerdiode ZD gebildet, die über die obere Isolierungsdiffusion 031/1 an die Emittermetallisierung 34/1 des als Schalttransistors arbeitenden Teiltransistors 54/1 (Figur 7) mit dem Emitter 061/3, der Basis 051/2 und dem Basiskontakt 151/2 angeschlossen ist. Der Anschlußfleck 41/1 geht über in die Metallisierung 43 zum Anschluß der buried-layer-Diffusion 001/1 über die hier geteilte Kollektoranschlußdiffusionen 041/1 und 041/2. Die buried-layer-Diffusion 001/1 erstreckt sich von der Linie cd aus nach oben. Das am Meßwiederstand 35/1 abfallende Potential ist über den Widerstand 36/1 mit der Sammelschiene 081 verbunden, die beispielsweise zu einer Regelschaltung führt; ebenso ist das masseseitige Potential des Widerstands 35/1 über den Widerstand 37/1 mit der Sammelschiene 082 verbunden, die ein vom Emitterstrom des Leistungstransistors unabhängiges Bezugspotential der Regelschaltung bereitstellt. Mit 31/2 ist der Anschlußfleck für den Emitter der nächsten Zelle angedeutet.

Die kräftigsten Linien in Figur 4 zeigen die Umrisse der Kontaktfenster, die beiden schwächsten die vom Emitter und buried layer, Die Basis ist nur wenig schwächer als die Kontaktfenster gezeichnet. Zusammen mit dem Schnitt AB nach Figur 5 lassen sich die entsprechenden Zonen eindeutig zuordnen. Alle Bezeichnungen stimmen mit denen der Figur 4 überein, neu ist das Silizumsubstrat 000 und die Epitaxialschicht 100.

Stehen Halbeiterprozesse beispielsweise mit Zweilagenmetalliserung und Polysilizium zur Verfügung, etwa wie in dem US-Patent 4 656 496 angewandt, so läßt sich die Emitterstromdichte des gesamten Leistungstransistors auch durch Auflösen der Emitterstruktur der Zellen in eine Vielzahl von Teilemittern mit jeweils einem Widerstand zwischen dem Teilemitter und dem Emitteranschluß stabilisieren. Auch eine zwischen Emitterdiffusionszone und darüberliegendem Metall eingebrachte Widerstandszone aus Polysilizium ist zur Stabilisierung der Emitterstromdichte ausführbar.

Im Betrieb ist die in den Zellen erzeugte Verlustwärme mindestens über die Grundplatte abzuführen. Liegt zwischen den beiden Zeilen mit Transistorzellen ein Abstand, der mindestens der Chipdicke entspricht, so sind beide Zeilen in etwa thermisch entkoppelt. Gegeben durch den Wärmewiderstand der Grundplatte werden die Zellen etwa in ihrer Mitte am wärmsten, das gleiche gilt wieder für jede der beiden Zeilen. Für Anfordnungen, in denen hohe Stoßbeanspruchungen vorkommen, ist es deshalb sinnvoll, die Emitterstromdichte und damit die Leistungsdichte etwa in der Mitte einer Zelle zu reduzieren und damit die Sperrschichttemperatur zu homogenisieren. Ebenso ist bei den Zellen zu verfahren, die innerhalb der Mitte einer Zeile liegen.

Im Ausschnitt einer Zelle nach Figur 6 ist die sich vom linken Ende bis etwa zur Mitte hin erstreckende Basis 051/1 des linearen Teiltransistors mit ihren beiden Emitterzonen 061/1 und 061/2, dem Basiskontakt 151/1 und den zwischen Basiskontakt und Emitterzonen liegenden jeweils einen Pinchwiderstand 38/1/1, 2 bildenden weiteren Emitterdiffusionszonen 061/4 und 061/5 wiedergegeben. Gegen die Mitte zu, ab a, werden die beiden Emitterdiffusionszonen breiter, bis sie bei b ihre größte Breite erreicht haben und in dieser Breite bis etwa zur Mitte der Zellänge verbleiben. Damit wird gegen die Mitte zu der Pinchwiderstand vergrößert, die Emitterstromdichte und damit auch die Verlustleistungsdichte herabgesetzt.

Konstengünstig zu fertigende monolithisch integrierte Leistungstransistoren erfordern eine hohe Flächenleistungsdichte, wie sie beispielsweise durch Löten auf eine Kupfergrundplatte zu erreichen ist. Da es in einer Großserie jedoch nicht gelingt, absolut lunkerfrei zu löten und bei der Schlußprüfung Exemplare mit feinen Lunkern sicher zu erfassen, ist ein "Selbstheileffekt" unabdingbar, um eine hohe Zuverlässigkeit zu erreichen. Methoden hierzu sind aus den Patentanmeldungen (PCT) WO 87/01867 bzw. DE-A-35 32 383 bekannt. Gegenüber diesen Vorschlägen kann es jedoch besonders vorteilhaft sein, die Kollektoren der einzelnen Zellen gegeneinander zu isolieren und in die Kollektorzuleitung zum Anschlußfleck eine Engstelle einzubauen. Wird ein Teil einer Zelle oder auch mehrerer Zellen durch einen darunterliegenden Lunker überhitzt, geht also in die Eigenleitung, so übernimmt der betroffene Teil nahezu den insgesamt mögliche Strom, die Engstelle(n) brennt (brennen) durch; damit ist die Zelle, in der der zerstörte Teil liegt, von dem gesund gebliebenen Rest des Leistungstransistors abgetrennt. Damit jetzt die mit ihrem Emitter verschmolzene Basis der zerstörten Zelle dem gesund gebliebenen Rest des Leistungstransistors nicht den Basisstrom wegnimmt, sind im einfachsten Fall Widerstände zwischen den Basisleitungen 151/1, 151/2 usw. und der Schaltung, die den Ansteuerstrom liefert, vorgesehen.

In Figur 7 kommen zu dem bereits Bekannten die Treiberschaltungen für den linear arbeitenden Teiltransistor 53/1 und den Schalttransistor 54/1. Die Basis von 53/1 mit ihrem Pinchwiderstand 38/1 ist über den Entkopplungswiderstand 45/1 mit dem Emitter des Treibertransistors 55/1 verbunden, dessen Basis an die Sammelschiene 085 für das lineare Steuersignal und dessen Kollektor über den Widerstand 47/1 mittels der Sammelschiene 083 an den positiven Pol der Stromversorgung angeschlossen ist. Die Basis des Schalttransistors 54/1 ist ebenfalls über einen Entkopplungswiderstand 46/1 mit dem Emitter des Treibertransistors 56/1 verbunden, dessen Basis an die Sammelschiene 084 für das Steuersignal des Schalttransistors und dessen Kollektor über den Widerstand 48/1 mittels der Sammelschiene 083 an den positiven Pol der Stromversorgung angeschlossen ist. Die gemeinsamen Kollektoren der Teiltransistoren 53/1 und 54/1 sind mit der Leitung 43/1, die die Engstelle 44/1 als "Brennstelle" aufweist, mit dem Anschlußfleck 41/1 verbunden. Die Steuerschaltung wiederholt sich für jede Zelle des Leistungstransistors.

Die Entkopplungswiderstände 45/1 und 46/1 können auch zwischen den Basen ihrer zugehörenden Treibertranssitoren 55/1, 56/1 und den Sammelleitungen 085 und 084 angeordnet sein.

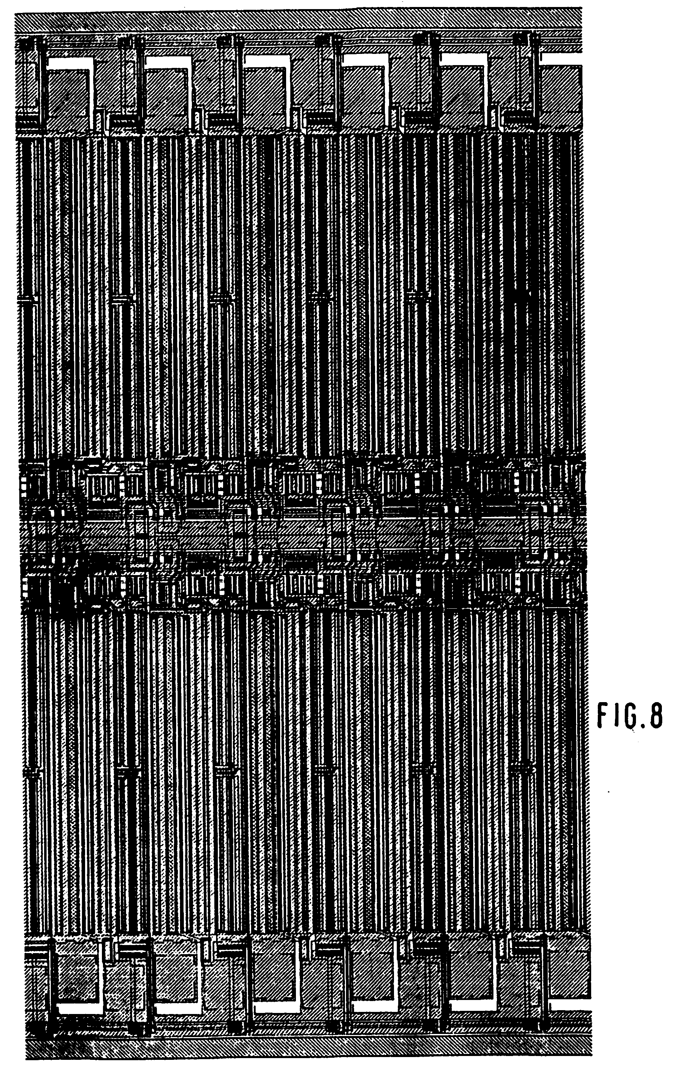

Figur 8 zeigt noch das Plot eines Layouts im Ausschnitt für den beschriebenen Leistungstranssitor in zweizeiliger Anordnung. Der mit der Steuerschaltung und Zenerdioden gefüllte Abstand zwischen den beiden Zeilen beträgt etwas mehr als 600 µm, was eine gute thermische Entkopplung der beiden Transistorenzeilen ergibt.

## Patentansprüche

1. Monolithisch, in einem Chip integrierter Leistungstransistor (22) bestehend aus der Parallelschaltung einer Vielzahl einzelner Transistorzellen, dadurch gekennzeichnet, daß die Transistorzellen zweizeilig angeordnet sind und jeweils mindestens einen Teiltransistor (53/1) mit einem Emitterbereich (061/1, 061/2), einem Basisbereich (051/1), einem Kollektorbereich (100, 001/1) und dazugehörenden Emitter-, Basis-, und Kollektormetallisierungen (331, 332, 151/1, 43/1) enthalten, daß jeder Zelle je ein nebeneinanderliegender Emitter- und Kollektoranschlußfleck (31/1, 41/1) für nach außen führende Anschlußleitungen (71/1, 81/1) zugeordnet ist, wobei die Emitter- und Kollektoranschlußflecken jeder Transistorzeile eine Fleckenzeile bilden, und daß die zweite Transistorzeile spiegelbildlich zur ersten so angeordnet ist, daß die Fleckenzeilen jeweils an gegenüberliegenden Außenkanten des Chips verlaufen.

2. Monolithisch integrierter Leistungstransistor nach Anspruch 1, dadurch gekennzeichnet, daß der Chip ein Siliziumchip ist und daß die beiden Transistorzeilen voneinander mittels eines Abstands getrennt sind und der Abstand mindestens gleich der Dicke des Siliziumchips ist.

3. Monolithisch integrierter Leistungstransistor nach Ansruch 2, dadurch gekennzeichnet, daß zwischen den beiden Transistorzeilen Versorgungsleitungen (083, 084, 085) angeordnet sind.

4. Monolithisch integrierter Leistungstransistor nach Anspruch 3, dadurch gekennzeichnet, daß zwischen den beiden Transistorzeilen neben Versorgungsleitungen weitere Schaltungsteile, beispielsweise Treiberstufen mit ihren zugehörenden Transistoren (55/1, 56/1) und Schaltungskomponenten sowie zum Schutz gegen Überspannung gegebenenfalls erforderliche Avalanchedioden, angeordnet sind.

5. Monolithisch integrierter Leistungstransistor nach einem der vorhergehenden Ansprüche, dadurch gekennzeichnet, daß die Transistorzellen länglich sind und jeweils einen länglichen Emitterbereich und einem Basiskontakt (151/1) aufweisen und daß für den Betrieb im linearen Bereich zur Stabilisierung der Stromdichte im Emitter entlang seiner Längsachse zwischen Basiskontakt und Emitterbereich einen weiteren Emitterbereich (061/4, 061/5), der einen Pinchwiderstand (38/1) bildet, angeordnet ist.

6. Monolithisch integrierter Leistungstransistor nach einem der vorhergehenden Ansprüche, dadurch gekennzeichnet, daß die Transistorzellen länglich sind und jeweils einen länglichen Emitterbereich, ein Emitterkontaktfenster und ein darüberliegendes Emittermetall aufweisen und daß für den Betrieb im linearen Bereich zur Stabilisierung der Stromdichte im Emitter entlang seiner Längsachse zwischen seinem Emitterkontaktfenster und dem darüberliegenden Emittermetall (331, 332) eine Widerstandsschicht, bevorzugt aus dotiertem Poly-Silizium, angeordnet ist.

7. Monolithisch integrierter Leistungstransistor nach einem der vorhergehenden Ansprüche, dadurch gekennzeichnet, daß die Transistorzellen länglich sind und daß die Stromdichte entlang der Längsachse einer Zelle veränderbar ist derart, daß die Zone mit geringerer Stromdichte im wärmeren Kern der Zelle, also im mittleren Bereich der Längsachse, die Zonen mit höherer Stromdichte in den kühleren Randzonen der Zelle angeordnet sind.

8. Monolithisch integrierter Leistungstransistor nach einem der vorhergehenen Ansprüche, dadurch gekennzeichnet, daß beim Aufbau einer Zelle aus mehr als einem Teiltransistor nicht alle Teiltransistoren einer Zelle mit gleicher Stromdichte betreibbar sind, wobei die Teiltransistoren mit geringerer Stromdichte im wärmeren Kern der Zelle, die mit höherer Stromdichte in den kühleren Randzonen der Zelle angeordnet sind.

9. Monolithisch integrierter Leistungstransistor nach einem der vorhergehenden Ansprüche, dadurch gekennzeichnet, daß nicht alle Zellen mit gleicher mittleren Stromdichte betreibbar sind, wobei die mittlere Stromdichte der Zellen, die im wärmeren Kern einer Zeile des aus einer Vielzahl von Zellen bestehenden Leistungstransistors angeordnet sind, geringer ist als die der an den beiden kühleren Enden einer Zeile des Leistungstransistors liegenden Zellen.

10. Monolithisch integrierter Leistungstransistor nach Anspruch 5, dadurch gekennzeichnet, daß die Breite der zwischen Basiskontakt und Emitterbereich liegenden den Pinchwiderstand bildenden weiteren Emitterbereiche entlang der Längsachse einer Zelle vergrößert ist, wobei die Stromdichte im länglichen Emitterbereich entlang der Längsachse einer Zelle bzw. in einem Teiltransistor entsprechend reduziert ist.

11. Monolithisch integrierter Leistungstransistor nach Anspruch 6, dadurch gekennzeicnet, daß die Breite des Emitterkontaktfensters entlang der Längsachse einer Zelle verringert ist, wobei die Stromdichte im länglichen Emitterbereich entlang der Längsachse einer Zelle bzw. in einem Teiltransistor entsprechend reduziert ist.

12. Monolithisch integrierter Leistungstransistor nach Anspruch 11, dadurch gekennzeichnet daß die Breite der zwischen Emitterkontaktfenster und Emittermetallisierung liegenden Widerstandsschicht entlang der Längsachse einer Zelle verringert ist, wobei die Stromdichte im länglichen Emitterbereich entlang der Längsachse einer Zelle bzw. in einem Teiltransistor entsprechend reduziert ist.

13. Monolithisch integrierter Leistungstransistor nach einem der vorhergehenden Ansprüche, dadurch gekennzeichnet, daß die Ermitterbereiche jeder Zelle mit einer Emitterverbindungsleitung, die jeweils entlang der Zelle angeordnet ist, versehen sind und daß zwischen der Emitterverbindungsleitung (33/1) und dem zugehörenden Anschlußfleck für den Emitterbereich ein Meßwiderstand (35/1) für den Emitterstrom angeordnet ist, wobei der Leistungstransistor sich für Anwendungen mit Stromregelung bzw. Strombegrenzung eignet.

14. Monolithisch integrierter Leistungstransistor nach Anspruch 13, dadurch gekennzeichnet, daß in einer zelle parallel zu dem ersten Transistor (53/1) ein zweiter Transistor (54/1) angeordnet ist, der keine seine Sättigungsspannung erhöhende Maßnahme aufweist und dessen Emitterbereich (061/3) unmittelbar mit dem Anschlußfleck für die Emitterbereiche einer Zelle verbunden ist.

15. Monolithisch integrierter Leistungstransistor nach einem der vorhergehenden Ansprüche, dadurch gekennzeichnet, daß die Transistorzellen eine hochdotierte vergrabene Kollektorschicht (001/1) und eine nach außen führende Sammelschiene für den Emitteranschluß aufweisen und daß zwischen der Sammelschiene einer Zelle und deren vergrabener Schicht eine auf der vergrabenen Schicht aufsitzende p-dotierte Zone (021/1, 031/1) angeordnet ist, die eine Avalanchediode bildet.

16. Monolithisch integrierter Leistungstransistor nach einem der vorhergehenden Ansprüche, dadurch gekennzeichnet, daß die Zellen gegeneinander isoliert sind und jeweils eine Metallisierung zwischen einem Anschlußfleck für den Kollektorbereich und der dazugehörenden Kollektormetallisierung aufweisen, wobei der Querschnitt der Metallisierung so ausgelegt ist, etwa mittels einer Engstelle (44/1), daß sich eine im Betrieb defekt werdende Zelle von den Kollektoren der intakten Zellen durch Abbrennen abzutrennen vermag.

17. Monolithisch integrierter Leistungstransistor nach Anspruch 16, dadurch gekennzeichnet, daß er Leitungszüge aufweist, welche den Basisanschluß jeder Zelle mit dem allen Zellen gemeinsamen Leitungszug für den Anschluß der Basis des Leistungstransistors verbinden und daß zur Entkopplung der Basisansteuerung einer defekten Zelle gegen die intakten Zellen Widerstände in die Leitungszüge geschaltet sind.

18. Monolithisch integrierter Leistungstransistor nach Anspruch 13, dadurch gekennzeichnet daß das emitterseitige Potential der an mindestens einem der Widerstände in den Emitterzuleitungen pro Zelle gewonnenen Signalspannung über einen Entkopplungswiderstand (36/1) mit einer Sammelleitung (081) verbunden ist, über die das dem Emitterstrom des Leistungstransistors proportionale Potential einem Regelkreis zuführbar ist.

19. Monolithisch integrierter Leistungstransistor nach Anspruch 13, dadurch gekennzeichnet, daß das masseseitige Potential der an mindestens einem der Widerstände in den Emitterzuleitungen pro Zelle gewonnenen Signalspannung über einen Entkopplungswiderstand (37/1) mit einer Sammelleitung (082) verbunden ist, über die ein masseseitiges, vom Emitterstrom des Leistungstransistors unabhängiges Referenzpotential einem Regelkreis zuführbar ist.

20. Monolithisch integrierter Leistungstransistor nach Anspruch 13, dadurch gekennzeichnet, daß der positive Temperaturkoeffizient des Strommeßwiderstands (35/1) einer Zelle mindestens teilweise mittels des über die Auslegung der Schaltung einstellbaren Temperaturkoeffizienten der zwischen Steuereingang und Basis des Leistungstransistors liegenden Steuerschaltungen kompensiert ist.

## Claims

1. Monolithic power transistor (22) integrated in a chip, consisting of the connection in parallel of a multiplicity of individual transistor cells, characterized in that the transistor cells are arranged in two rows and each contain at least one transistor element (53/1) having an emitter region (061/1, 061/2) a base region (051/1), a collector region (100, 001/1 and associated emitter, base and collector metallizations (331, 332, 151/1, 43/1), in that every cell is assigned an adjacent emitter and collector bonding pad (31/1, 41/1) for connection lines (71/1, 81/1) leading outwards, the emitter and collector bonding pads of each transistor row forming a pad row, and in that the second transistor row is arranged, as the mirror image of the first, in such a way that the pad rows each run along opposite outer edges of the chip.

2. Monolithic integrated power transistor according to Claim 1, characterized in that the chip is a silicon chip, and in that the two transistor rows are separated from each other by an interval and the interval is at least equal to the thickness of the silicon chip.

3. Monolithic integrated power transistor according to Claim 2, characterized in that supply lines (083, 084, 085) are arranged between the two transistor rows.

4. Monolithic integrated power transistor according to Claim 3, characterized in that, in addition to supply lines, other circuit parts, for example driver stages with their associated transistors (55/1, 56/1) and circuit components and avalanche diodes which may possibly be required for protection against overvoltage, are arranged between the two transistor rows.

5. Monolithic integrated power transistor according to one of the preceding claims, characterized in that the transistor cells are elongate and each have an elongate emitter region and a base contact (151/1) and in that, for operation in the linear range, a further emitter region (061/4, 061/5), which forms a pinch resistor (38/1), is arranged between the base contact and the emitter region in order to stabilize the current density in the emitter along its longitudinal axis.

6. Monolithic integrated power transistor according to one of the preceding claims, characterized in that the transistor cells are elongate and each have an elongate emitter region, an emitter contact window and an overlying emitter metal and in that, for operation in the linear range, a resistive layer, preferably of doped polysilicon, is arranged between the emitter's emitter contact window and the overlying emitter metal (331, 332) in order to stabilize the current density in the emitter along its longitudinal axis.

7. Monolithic integrated power transistor according to one of the preceding claims, characterized in that the transistor cells are elongate and in that the current density along the longitudinal axis of a cell can be varied in such a way that the zone with lower current density are arranged in the hotter core of the cell, that is to say in the central region of the longitudinal axis, and the zones with higher current density are arranged in the cooler edge zones of the cell.

8. Monolithic integrated power transistor according to one of the preceding claims, characterized in that when a cell is constructed from more than one transistor element, not all of the transistor elements of a cell can be operated with the same current density, the transistor elements with lower current density being arranged in the hotter core of the cell, and the transistor elements with higher current density being arranged in the cooler edge zones.

9. Monolithic integrated power transistor according to one of the preceding claims, characterized in that not all of the cells can be operated with the same average current density, the average current density of the cells which are arranged in the hotter core of a row of the power transistor which consists of a multiplicity of cells being less than that of the cells located at the two cooler ends of a row of the power transistor.

10. Monolithic integrated power transistor according to Claim 5, characterized in that the width of the further emitter regions, located between the base contact and the emitter region and forming the pinch resistor, is increased along the longitudinal axis of a cell, the current density in the elongate emitter region being correspondingly reduced along the longitudinal axis of a cell or in a transistor element.

11. Monolithic integrated power transistor according to Claim 6, characterized in that the width of the emitter contact window is reduced along the longitudinal axis of a cell, the current density in the elongate emitter region being correspondingly reduced along the longitudinal axis of a cell or in a transistor element.

12. Monolithic integrated power transistor according to Claim 11, characterized in that the width of the resistive layer located between the emitter contact window and the emitter metallization is reduced along the longitudinal axis of a cell, the current density in the elongate emitter region being correspondingly reduced along the longitudinal axis of a cell or in a transistor element.

13. Monolithic integrated power transistor according to one of the preceding claims, characterized in that the emitter regions of each cell are provided with an emitter connection line which is in each case arranged along the cell and in that a measuring resistor (35/1) for the emitter current is arranged between the emitter connection line (33/1) and the associated bonding pad for the emitter region, the power transistor being suitable for application with current control or current limitation.

14. Monolithic integrated power transistor according to Claim 13, characterized in that, in a cell, a second transistor (54/1) which has no measures which increase its saturation voltage and whose emitter region (061/3) is directly connected to the bonding pad for the emitter regions of a cell, is arranged in parallel with the first transistor (53/1).

15. Monolithic integrated power transistor according to one of the preceding claims, characterized in that the transistor regions have a heavily doped buried collector layer (001/1) and a bus, for the emitter electrode, leading outwards and in that a p-doped zone (021/1, 031/1), which forms an avalanche diode and is located on top of the buried layer, is arranged between the bus of a cell and its buried layer.

16. Monolithic integrated power transistor according to one of the preceding claims, characterized in that the cells are insulated from one another and each have a metallization between a bonding pad for the collector region and the associated collector metallization, the cross-section of the metallization being configured, for example by means of a constriction (44/1), in such a way that a cell which becomes defective during operation can be disconnected from the collectors of the intact cells by burning out.

17. Monolithic integrated power transistor according to Claim 16, characterized in that it has wiring runs which join the base terminal of each cell to the wiring run, for connecting the base of the power transistor, common to all the cells and in that resistors are connected into the wiring runs for decoupling the base control of a defective cell from the intact cells.

18. Monolithic integrated power transistor according to Claim 13, characterized in that the emitter-side potential of the signal voltage obtained at at least one of the resistors in the emitter feed lines per cell is connected via a decoupling resistor (36/1) to a bus line (081) via which the potential proportional to the emitter current of the power transistor can be fed to a control circuit.

19. Monolithic integrated power transistor according to Claim 13, characterized in that the earth-side potential of the signal voltage obtained at at least one of the resistors in the emitter feed lines per cell is connected via a decoupling resistor (37/1) to a bus line (082) via which an earth-side reference potential, independent of the emitter current of the power transistor, can be fed to a control circuit.

20. Monolithic integrated power transistor according to Claim 13, characterized in that the positive temperature coefficient of the current-measuring resistor (35/1) of a cell is compensated for at least partly by means of the temperature coefficients, adjustable by means of the configuration of the circuit, of the control circuits located between the control input and the base of the power transistor.

## Revendications

1. Transistor de puissance (22) intégré dans une puce, monolithique composé d'un montage en parallèle d'un grand nombre de cellules de transistors différentes, caractérisé en ce que,
les cellules de transistors sont réparties en deux lignes et comportent chaque fois au moins un transistor partiel (53/1) avec une zone d'émetteur (061/1, 061/2), une zone de base (051/1), une zone de collecteur (100, 001/1) et des métallisations d'émetteur, de base et de collecteur correspondantes (331, 332, 151/1, 43/1), chaque cellule comportant une tache de branchement d'émetteur et de collecteur (31/1, 41/1), juxtaposés pour des lignes de branchement reliées à l'extérieur (71/1, 81/1) et les taches de branchement d'émetteur et de collecteur de chaque ligne de transistor forment une ligne de taches et la seconde ligne de transistor symétrique plane par rapport à la première ligne, les lignes de taches étant disposées chaque fois suivant les arêtes extérieures opposées de la puce.

2. Transistor de puissance, intégré, monolithique selon la revendication 1,
caractérisé en ce que,
la puce est une puce de silicium et les deux lignes de transistors sont séparées l'une de l'autre par un intervalle égal au moins à l'épaisseur de la puce de silicium.

3. Transistor de puissance, intégré, monolithique selon la revendication 2,
caractérisé en ce que,
entre les deux lignes de transistors, il y a des lignes d'alimentation (083, 084, 085).

4. Transistor de puissance, intégré, monolithique selon la revendication 3,
caractérisé en ce que,
entre les deux lignes de transistors, à côté des lignes d'alimentation, se trouvent d'autres parties de circuit par exemple des étages d'entraînement et leurs transistors correspondants (55/1, 56/1) et les composants de circuit ainsi que les diodes d'avalanche, éventuellement nécessaires pour la protection contre la surtension.

5. Transistor de puissance, intégré, monolithique selon l'une des revendications précédentes,
caractérisé en ce que,
les transistors sont allongés et comportent chaque fois une tache émetteur, allongée et un contact de base (151/1), et pour le fonctionnement linéaire, pour stabiliser la densité de courant dans l'émetteur, le long de son axe longitudinal, entre le contact de base et la zone de contact d'émetteur, il y a une autre tache émetteur (061/4, 061/5), formant une résistance de pincement (38/1).

6. Transistor de puissance, intégré, monolithique selon l'une des revendications précédentes,
caractérisé en ce que,
les cellules de transistors sont allongées et comportent chaque fois une tache émetteur, allongée, une fenêtre de contact émetteur et par-dessus un métal émetteur et pour le fonctionnement dans la zone linéaire, pour stabiliser la densité de courant dans l'émetteur, le long de son axe longitudinal, entre sa fenêtre de contact émetteur et le métal émetteur superposés (331, 332), on a une couche résistante, de préférence du polysilicium dopé.

7. Transistor de puissance, intégré, monolithique selon l'une des revendications précédentes,
caractérisé en ce que,
les cellules de transistors sont allongées et comportent chaque fois une tache émetteur, allongée, une fenêtre de contact émetteur et par-dessus, un métal émetteur et la densité de courant le long de l'axe longitudinal d'une cellule est variable de façon que le zone de plus faible densité de courant se trouve au niveau du noyau le plus chaud de la cellule, c'est-à-dire dans la zone médiane selon l'axe longitudinal et les zones à plus forte densité de courant se trouvent dans les zones marginales plus froides de la cellule.

8. Transistor de puissance, intégré, monolithique selon l'une des revendications précédentes,
caractérisé en ce que,
lors de la réalisation d'une cellule à partir de plus d'un transistor partiel, tous les transistors partiels d'une cellule ne fonctionnent pas avec la même densité de courant, les transistors partiels à plus faible densité de courant se trouvant dans le coeur plus chaud de la cellule et ceux avec une densité de courant plus élevée se trouvant dans les zones marginales plus froides de la cellule.

9. Transistor de puissance, intégré, monolithique selon l'une des revendications précédentes,
caractérisé en ce que,
toutes les cellules ne fonctionnent pas avec la même densité moyenne de courant, la densité moyenne de courant des cellules correspondant au coeur le plus chaud d'une ligne du transistor de puissance composé d'un grand nombre de cellules étant inférieure à celle des cellules se trouvant aux deux extrémités plus froides d'une cellule du transistor de puissance.

10. Transistor de puissance, intégré, monolithique selon la revendication 5,
caractérisé en ce que,
la largeur de l'autre zone d'émetteur formant la résistance de pincement entre le contact de base et la tache émetteur, est augmentée le long de l'axe longitudinal d'une cellule, la densité de courant dans la tache émetteur allongée le long de l'axe longitudinal d'une cellule ou d'un transistor partiel étant réduite de manière correspondante.

11. Transistor de puissance, intégré, monolithique selon la revendication 6,
caractérisé en ce que,
la largeur de la fenêtre de contact émetteur est réduite le long de l'axe longitudinal d'une cellule et la densité de courant dans la tache émetteur longitudinale le long de l'axe longitudinal d'une cellule ou d'un transistor partiel est réduite de manière correspondante.

12. Transistor de puissance, intégré, monolithique selon la revendication 11,
caractérisé en ce que,
la largeur de la couche de résistance comprise entre la fenêtre de contact de l'émetteur et la métallisation de l'émetteur le long de l'axe longitudinal d'une cellule est réduite et la densité de courant dans la tache émetteur longitudinale suivant l'axe longitudinal d'une cellule ou dans un transistor partiel est réduite de manière correspondante.

13. Transistor de puissance, intégré, monolithique selon l'une des revendications précédentes,
caractérisé en ce que,
la tache émetteur de chaque cellule avec une ligne de liaison émetteur est prévue chaque fois le long de la cellule et entre la ligne de liaison émetteur (33/1) et la tache de branchement correspondante pour la tache émetteur, se trouve une résistance de mesure (35/1) pour le courant émetteur, le transistor de puissance étant applicable à la régulation ou à la limitation de l'intensité d'un courant.

14. Transistor de puissance, intégré, monolithique selon la revendication 13,
caractérisé en ce que,
dans une cellule, en parallèle au premier transistor (53/1) on a un second transistor (54/1) ne comportant pas de moyen augmentant sa tension de saturation et dont la tache émetteur (061/3) est reliée directement à la tâche de branchement de la tache émetteur d'une cellule.

15. Transistor de puissance, intégré, monolithique selon l'une des revendications précédentes,
caractérisé en ce que,
les cellules de transistors comportent une couche de collecteur noyée, fortement dopée (001/1) et un rail collecteur conduisant à l'extérieur pour le branchement émetteur et en ce qu'entre le rail collecteur d'une cellule et la couche noyée, on a une zone à dopage (p) sur la couche noyée (021/1, 031/1) formant une diode à effet d'avalanche.

16. Transistor de puissance, intégré, monolithique selon l'une des revendications précédentes,
caractérisé en ce que,
les cellules sont isolées les unes par rapport aux autres et en ce que chaque fois une métallisation est prévue entre une tâche de branchement pour la zone collecteur et la métallisation de collecteur correspondante, la section de la métallisation étant telle que sensiblement par un point d'étranglement (44/1), une cellule de fonctionnement devenant défectueuse, peut se détacher des collecteurs des cellules intactes par fusion.

17. Transistor de puissance, intégré, monolithique selon la revendication 16,
caractérisé en ce qu',
il comporte des lignes de puissance qui relient le branchement de base de chaque cellule à la ligne de liaison commune à toutes les cellules pour le branchement de la base du transistor de puissance et pour découpler la commande de base d'une cellule défectueuse par rapport aux cellules intactes, les lignes de liaison comportent des résistances.

18. Transistor de puissance, intégré, monolithique selon la revendication 13,
caractérisé en ce que,
le potentiel du côté de l'émetteur au moins sur l'une des résistances dans les lignes d'alimentation de l'émetteur par cellule pour une tension de signal obtenue, est relié par une résistance de découplage (36/1) à une ligne collectrice (081) par laquelle le potentiel proportionnel au courant émetteur du transistor de puissance est appliqué à un circuit de régulation.

19. Transistor de puissance, intégré, monolithique selon la revendication 13,
caractérisé en ce que,
le potentiel du côté de la masse de la tension de signal obtenue sur au moins l'une des résistances dans les lignes d'alimentation d'émetteur par cellule, est appliqué par une résistance de découplage (37/1) à un collecteur (082) qui fournit à un circuit de régulation, un potentiel de référence du côté de la masse, indépendant du courant émetteur du transistor de puissance.

20. Transistor de puissance, intégré, monolithique selon la revendication 13,
caractérisé en ce que,
le coefficient de température positif de la résistance de courant (35/1) d'une cellule est compensé au moins partiellement par les coefficients de température réglables par la conception du circuit, pour les circuits de commande situés entre l'entrée de commande et la base du transistor de puissance.
